(19)

Europäisches Patentamt

European Patent Office

Office européen des brevets

(11) **EP 4 394 502 A1**

(12) **EUROPEAN PATENT APPLICATION**

(43) Date of publication:
**03.07.2024 Bulletin 2024/27**

(21) Application number: **22216697.7**

(22) Date of filing: **27.12.2022**

(51) International Patent Classification (IPC):
**G03F 7/00** $^{(2006.01)}$    **G05B 19/416** $^{(2006.01)}$

(52) Cooperative Patent Classification (CPC):
**G03F 7/70725**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventors:
- **BUTLER, Hans
  5500 AH Veldhoven (NL)**
- **KAMIDI, Ramidin, Izair
  5500 AH Veldhoven (NL)**

(74) Representative: **ASML Netherlands B.V.
Corporate Intellectual Property
P.O. Box 324
5500 AH Veldhoven (NL)**

(54) **METHOD TO GENERATE AN ACCELERATION SETPOINT PROFILE FOR A MOVABLE OBJECT, SETPOINT GENERATOR AND LITHOGRAPHIC APPARATUS**

(57)    The invention provides a method to generate an acceleration setpoint profile for a movable object, wherein the method comprises:
providing a time domain acceleration curve with finite acceleration time length, providing a time domain jerk curve with finite jerk time length,
calculating a time domain convolution of the time domain acceleration curve and the time domain jerk curve to generate the acceleration setpoint profile,
wherein the time domain jerk curve has a zero value at a start and an end of the finite jerk time length, and wherein an amplitude profile of the time domain jerk curve, when Fourier transformed into frequency domain, has an amplitude that decreases for higher frequencies with at least 60 dB per decade.

$$J \quad * \quad A \quad = \quad AP$$

$$t_j \qquad t_a \qquad t_j + t_a$$

**Fig. 4**

EP 4 394 502 A1

**Description**

FIELD

The present invention relates to a method to generate an acceleration setpoint profile for a movable object. The invention further relates to a setpoint generator and a lithographic apparatus.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In a lithographic apparatus movable objects may be used of which the position needs to be controlled with high accuracy. Such a movable object is for example a substrate support or a patterning device support. In some lithographic apparatus, the position of optical elements of the projection system may also be actively controlled. Setpoint generators are used to generate a setpoint profile to be followed by the movable object. In case the movements have to be followed with high accuracy, the setpoint profile may be an acceleration setpoint profile defining a desired acceleration over time for the movable object.

In presently used acceleration setpoint profiles, higher resonances of the movable object may still be excited which results in less accurate positioning and/or larger settling times.

SUMMARY

It is an object of the invention to provide a method to generate an alternative acceleration setpoint profile that is capable of reducing the excitation of higher resonances of the movable object. It is another object of the invention to provide a setpoint generator adapted to generate such alternative acceleration setpoint profile and a lithographic apparatus having such setpoint generator.

According to an aspect of the invention, there is provided a method to generate an acceleration setpoint profile for a movable object, wherein the method comprises:

   providing a time domain acceleration curve with finite acceleration time length, providing a time domain jerk curve with finite jerk time length,
   calculating a time domain convolution of the time domain acceleration curve and the time domain jerk curve to generate the acceleration setpoint profile,
   wherein the time domain jerk curve has a zero value at a start and an end of the finite jerk time length, and
   wherein an amplitude profile of the time domain jerk curve, when Fourier transformed into frequency domain, has an amplitude that decreases for higher frequencies with at least 60 dB per decade.

According to an aspect of the invention, there is provided a setpoint generator arranged to generate an acceleration setpoint profile for a movable object, using a time domain acceleration curve with finite acceleration time length and a time domain jerk curve with finite jerk time length,

   wherein the setpoint generator is arranged to calculate a time domain convolution of the time domain acceleration curve and the time domain jerk curve to generate the acceleration setpoint profile,
   wherein the time domain jerk curve has a zero value at a start and an end of the finite jerk time length, and
   wherein an amplitude profile of the time domain jerk curve, when Fourier transformed into frequency domain, has an amplitude that decreases for higher frequencies with at least 60 dB per decade.

According to an aspect of the invention, there is provided a lithographic apparatus comprising a setpoint generator arranged to generate an acceleration setpoint profile for a movable object, using a time domain acceleration curve with finite acceleration time length and a time domain jerk curve with finite jerk time length,

wherein the setpoint generator is arranged to calculate a time domain convolution of the time domain acceleration curve and the time domain jerk curve to generate the acceleration setpoint profile,
wherein the time domain jerk curve has a zero value at a start and an end of the finite jerk time length, and
wherein an amplitude profile of the time domain jerk curve, when Fourier transformed into frequency domain, has an amplitude that decreases for higher frequencies with at least 60 dB per decade.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a detailed view of a part of the lithographic apparatus of Figure 1;
- Figure 3 schematically depicts a position control system;
- Figure 4 depicts schematically a time domain convolution of a rectangular pulse shaped acceleration curve and a rectangular pulse shaped jerk curve to generate an acceleration setpoint profile;
- Figure 5 depicts schematically a time domain convolution of a rectangular pulse shaped acceleration curve and a raised cosine jerk curve to generate an acceleration setpoint profile;
- Figure 6 depicts schematically a time domain convolution of a rectangular pulse shaped acceleration curve and a Gaussian shaped jerk curve to generate an acceleration setpoint profile; and
- Figure 7 depicts schematically acceleration-frequency plots of the acceleration setpoint profiles obtained with the convolutions of Figures 4, 5 and 6.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

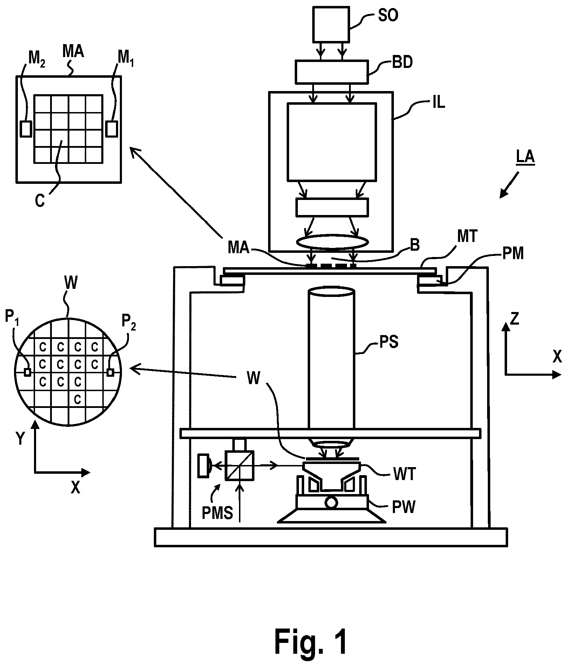

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system PMS, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

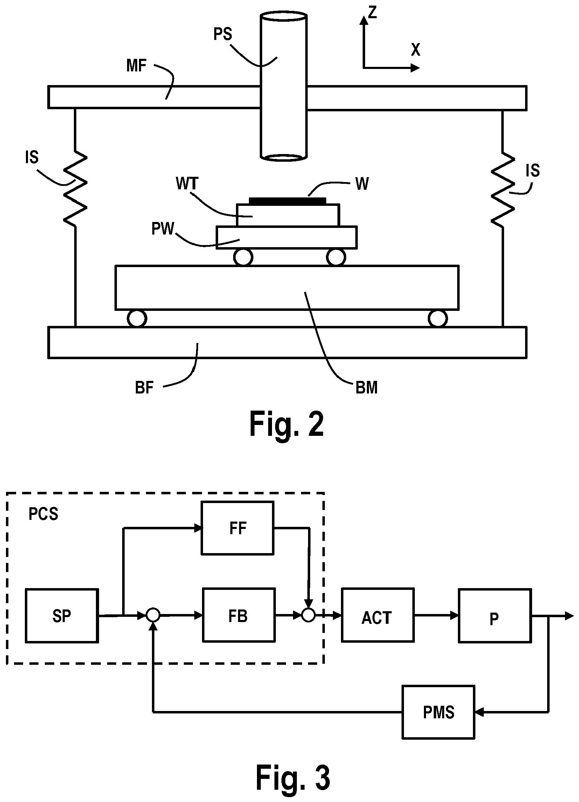

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor. a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from

for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example,+1$^{st}$ order, -1$^{st}$ order, +2$^{nd}$ order and -2$^{nd}$ order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads are arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electro-magnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

The lithographic apparatus LA comprises a position control system PCS as schematically depicted in Figure 3. The position control system PCS comprises a setpoint generator SP, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P.

The setpoint generator SP generates a signal, which is a reference signal representative of a desired position quantity of the plant P. For example, the reference signal represents a desired position of the substrate support WT. The desired position of the substrate support WT may be determined by double integrating an acceleration setpoint profile of the substrate support WT. A difference between the reference signal and the actual position signal forms an input for the feedback controller FB. Based on the input, the feedback controller FB provides at least part of the drive signal for the actuator ACT. The setpoint generator SP may also provide a feedforward reference signal as an input for the feedforward controller FF. This feedforward reference signal may be a desired position, a desired acceleration and/or another derivative of the desired position, such as a desired velocity, jerk or snap. Based on the input, the feedforward controller FF provides a further part of the drive signal for the actuator ACT. The feedforward FF may make use of information about dynamical characteristics of the plant P, such as mass, stiffness, resonance modes and eigenfrequencies.

In embodiments of presently used setpoint generators, the setpoint generator SP is arranged to generate a desired position, i.e. a position setpoint, that may be calculated from an acceleration setpoint profile. The acceleration setpoint profile is a series of acceleration setpoints over time, i.e. desired accelerations of the the substrate support WT at different points in time. The acceleration setpoint profile itself or signals based thereon may be used for position controller, for example by the feedforward controller FF. The position control system PCS is arranged to control the acceleration and position of the substrate support WT with high accuracy by controlling using feedback and/or feedforward based on, for example the desired position and the desired acceleration setpoint profile.

The acceleration setpoint profile may be generated as a time domain convolution of signal curves.

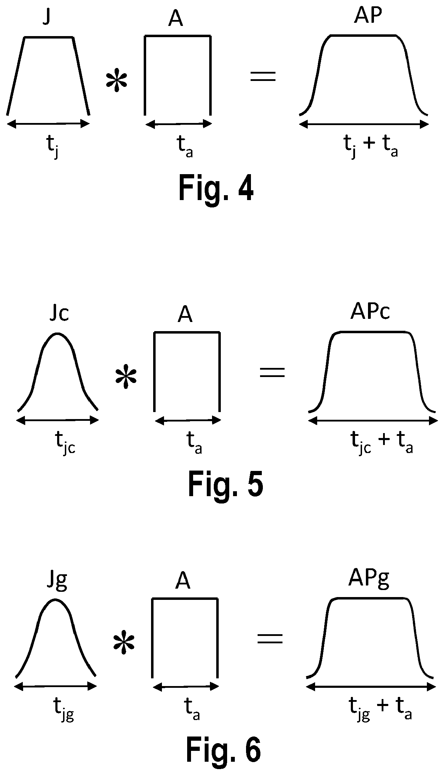

Figure 4 shows schematically a time domain convolution of a jerk curve J having jerk curve time $t_j$ and an acceleration curve A having acceleration curve time $t_a$ to create an acceleration setpoint profile AP with acceleration setpoint profile time $t_j + t_a$. The jerk curve J has a trapezium shape and may be formed by convolution of two rectangular pulse shaped curves represented as a rectangular pulse shaped snap curve PSS having snap curve time $t_{pss}$ and a rectangular pulse shaped jerk curve PSJ having jerk curve time $t_{psj}$, wherein $t_{pss} + t_{psj} = t_j$. The acceleration curve A is also a rectangular pulse shaped curve.

The convolution of the rectangular pulse shaped snap curve PSS and the rectangular pulse shaped jerk curve PSJ can be described in the frequency domain as:

$$\frac{\sin(\pi t_{pss} f)}{\pi t_{pss} f} \times \frac{\sin(\pi t_{psj} f)}{\pi t_{psj} f}$$

The amplitude profile of the resulting jerk curve with trapezoid shape has an amplitude, in the frequency domain that decreases for higher frequencies with 40 dB per decade. Higher frequencies are for example frequencies above the bandwidth of the position control system PCS.

Correspondingly, the acceleration setpoint profile AP shown in Figure 4 is a time domain convolution of the trapezium shaped jerk curve J and the rectangular pulse shaped acceleration curve A. This convolution can be described in the frequency domain as:

$$\frac{\sin(\pi t_{pss} f)}{\pi t_{pss} f} \times \frac{\sin(\pi t_{psj} f)}{\pi t_{psj} f} \times \frac{\sin(\pi t_a f)}{\pi t_a f}$$

The amplitude of the resulting acceleration setpoint profile AP has an amplitude, in the frequency domain, that decreases for higher frequencies with 60 dB per decade.

Although this slope of -60 dB per decade dampens high frequency content of the acceleration profile, higher frequencies may still be excited . It is therefore desirable to further reduce the high frequency content of the acceleration setpoint profile AP which is used as setpoint profile for the substrate support WT.

To reduce the high frequency content, the acceleration setpoint profile AP could be adapted to completely remove the high frequency content of the acceleration setpoint profile AP. This would however result in a non-causal time-domain profile with infinite length. Such time-domain profile can practically not be used as an acceleration setpoint profile for a movable object, such as the substrate support WT, since there is only limited time available for actuating the movable object.

The present invention proposes to generate an acceleration setpoint profile for a movable object using a time domain acceleration curve with finite acceleration time length and an alternative embodiment of a time domain jerk curve with finite jerk time length. The time domain jerk curve is selected to have an amplitude profile that, when Fourier transformed into frequency domain, has an amplitude that decreases for higher frequencies with at least 60 dB per decade. Higher frequencies are for example frequencies above the bandwidth of the position control system PCS. As a result, the amplitude of the acceleration setpoint profile based on a convolution of a rectangular pulse shaped acceleration curve and the alternative embodiment of a jerk curve, when Fourier transformed into frequency domain, will decrease for higher frequencies with at least 80 dB per decade.

Further, the time domain jerk curve has a zero value at a start and an end of the finite jerk time length. This provides a smooth transition at the beginning and the end of the jerk curve.

The setpoint generator SP is arranged to calculate a time domain convolution of the time domain acceleration curve and the time domain jerk curve to generate the acceleration setpoint profile.

The use of such alternative embodiment of a time domain jerk curve in combination with the time domain acceleration curve, for example a rectangular pulse shaped acceleration curve, may substantially reduce the high frequency content of the acceleration setpoint profile.

Figure 5 shows a first example of an improved jerk curve Jc having a raised cosine shape that is used in a time domain convolution with a rectangular pulse shaped acceleration curve A to generate an acceleration setpoint profile APc. The rectangular pulse shaped acceleration curve A may be the same as the rectangular pulse shaped acceleration curve A used in the convolution of Figure 4. The raised cosine shape may be defined as:

$$\frac{\cos(2\pi t/t_{jc}) + 1}{2}, \quad -0.5t_{jc} < t < 0.5t_{jc},$$

wherein t is time and $t_{jc}$ is the time length of the raised cosine jerk curve Jc. The time length $t_{jc}$ of the raised cosine jerk curve Jc.

The time length $t_{jc}$ may be the same as the time length $t_j$ of the rectangular pulse shape jerk curve, which results in that the total time length $t_j + t_a$ of the acceleration setpoint profile AP and the total time length $t_{jc} + t_a$ of the acceleration setpoint profile APc are the same.

The convolution can be described in the frequency domain as:

$$\frac{\sin(\pi t_a f)}{\pi t_a f} \times \frac{\sin(\pi t_{jc} f)}{\pi t_{jc} f} \cdot \frac{1}{2\left(1 - (ft_{jc})^2\right)} \left(\text{for } ft_{jc} \neq 1\right)$$

wherein f is the frequency, $t_a$ is the time length of the time domain acceleration curve and $t_{jc}$ is the time length of the time domain raised cosine shaped jerk curve.

This jerk curve has an amplitude profile, when Fourier transformed into frequency domain, that decreases for higher frequencies with 60 dB per decade. This means that the high frequency content of the acceleration setpoint profile is less dominant and higher frequency will be less excited. This may substantially improve accuracy of and/or reduce settling times in positioning of the substrate support WT.

The acceleration setpoint profile APc generated by the time domain convolution shown in Figure 5 can be described as a function of time during the jerk phase with the following function:

$$a(t) = \frac{1}{2}\left(t + \frac{t_{jc}}{2\pi} \sin\left(\frac{2\pi t}{t_{jc}}\right)\right)$$

wherein a(t) is the acceleration setpoint profile, wherein t is time and $t_{jc}$ is the time length of the time domain jerk curve.

Thus, a(t) is a combination of linear part and a sinusoidal part when rising from zero to its maximum. In the frequency domain, the amplitude of the acceleration setpoint AP profiles decreases, for higher frequencies, with -80 dB per decade.

Figure 6 shows another embodiment of a convolution of a rectangular pulse shaped acceleration curve and an alternatively shaped jerk curve Jg to generate an acceleration setpoint profile APg with finite time length $t_j + t_a$. In this embodiment, the time domain jerk curve Jg comprises a Gaussian shape. This Gaussian shape is provided with an offset, the offset being arranged to start and end the Gaussian shape at a zero value.

The time domain Gaussian shape may be defined as:

$$e^{-\frac{(t/t_{jg})^2}{2c^2}} - e^{-\left(\frac{1}{8c^2}\right)}, -0.5t_{jg} < t < 0.5t_{jg},$$

wherein t is time, $t_{jg}$ is the time length of the jerk curve and c is a tunable width parameter of the Gaussian curve.

In this embodiment, the term $e^{-\left(\frac{1}{8c^2}\right)}$ is used to remove offset, i.e. to have a start value of 0 at the begin and end of the jerk curve. This can be done by selecting constant c such that the Gaussian shape is provided with an offset that ensures that the jerk curve starts and ends at a zero value.

The time length $t_{jg}$ may be the same as the time length $t_j$ of the rectangular pulse shape jerk curve, which results in that the total time length $t_j + t_a$ of the acceleration setpoint profile AP and the total time length $t_{jg} + t_a$ of the acceleration setpoint profile APg are the same.

The convolution of the rectangular pulse shaped acceleration curve A and jerk curve Jg with Gaussian shape can be described in the frequency domain as:

$$\frac{\sin(\pi t_a f)}{\pi t_a f} \times c\sqrt{2\pi} \, e^{-\frac{(2\pi f t_{jg} c)^2}{2}}$$

wherein f is the frequency, $t_a$ is the time length of the time domain acceleration curve, $t_{jg}$ is the time length of the time domain jerk curve and c is a tunable width parameter of the Gaussian curve.

In the frequency domain, the amplitude of the jerk curve Jg with Gaussian shape decreases, for higher frequencies, exponentially, and the acceleration curve A decreases, for higher frequencies, with 20 dB per decade. Thus the amplitude of the acceleration setpoint profile APg for higher frequencies decreases with at least 80 dB per decade. This acceleration setpoint profile APg may therefore also substantially improve accuracy of and/or reduce settling times in positioning of the substrate support WT.

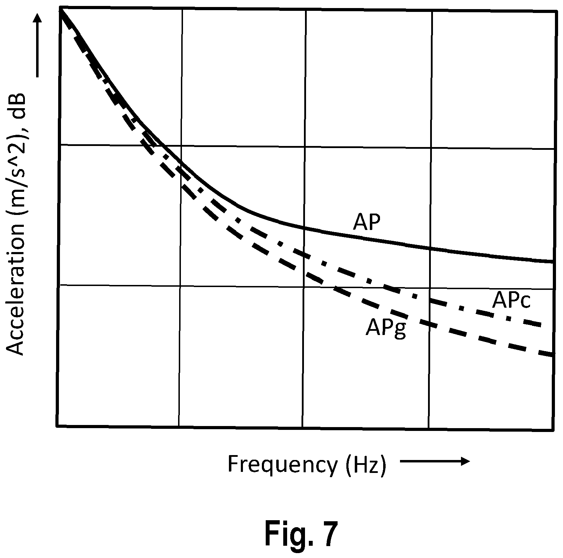

Figure 7 shows schematically an acceleration (amplitude) - frequency diagram of the acceleration setpoint profiles AP, APc, APg obtained by the convolutions of Figure 4 (solid line), Figure 5 (dash dot line) and Figure 6 (dashed line), respectively. It can be seen that for higher frequencies the amplitude of the acceleration setpoint profile AP generated with the convolution of Figure 4 decreases less fast than the amplitude of the acceleration setpoint profiles APc, APg generated with the convolutions of Figure 5 and 6, i.e. acceleration setpoint profiles which are generated based on jerk curve Jc having a squared raised cosine shape or a jerk curve Jg having Gaussian shape. As a result, in these acceleration setpoint profiles, higher frequency resonances of the movable object will be less excited with these novel acceleration setpoint profiles. The used of these adapted acceleration setpoint profiles may result in more accurate positioning and/or smaller settling times.

Hereinabove, embodiments of jerk curves are described for generating an acceleration setpoint profile based on a time domain convolution of the jerk curve and a rectangular pulse shaped acceleration curve. In these embodiments, a jerk curve having a squared raised cosine shape and a jerk curve having a Gaussian shape are proposed.

In alternative embodiments, other jerk curve shapes can be applied, as long as they have a finite time length, a zero start value and a zero end value, and an amplitude profile that decreases for higher frequencies with at least 60 dB per decade. The amplitude profile of the time domain jerk curve, when Fourier transformed into the frequency domain, may for example have an amplitude that decreases for higher frequencies with at least 80 dB per decade, or at least 100 dB per decade.

These alternative embodiments may for example have a jerk curve with a square raised cosine shape, a jerk curve comprising a combination of a raised cosine shape and an Gaussian shape, or other combination of curves that result in a jerk curve having the characteristics defined in claim 1.

Hereinabove, acceleration setpoint profiles for a substrate support are described. These acceleration setpoint profiles may also be applied in a position control system for any other movable object that has to be controlled with high accuracy. Such movable object may be a part of a projection system of a lithographic apparatus or another movable object of a lithographic apparatus, but also other movable objects.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Examples

1. A method to generate an acceleration setpoint profile for a movable object, wherein the method comprises:

providing a time domain acceleration curve with finite acceleration time length, providing a time domain jerk curve with finite jerk time length,
calculating a time domain convolution of the time domain acceleration curve and the time domain jerk curve to generate the acceleration setpoint profile,
wherein the time domain jerk curve has a zero value at a start and an end of the finite jerk time length, and
wherein an amplitude profile of the time domain jerk curve, when Fourier transformed into frequency domain, has an amplitude that decreases for higher frequencies with at least 60 dB per decade.

2. The method of example 1, wherein the time domain jerk curve comprises a raised cosine shape.
3. The method of example 2, wherein the raised cosine shape is defined as:

$$\frac{\cos(2\pi t/t_{jc})+1}{2}, \quad -0.5t_{jc} < t < 0.5t_{jc},$$

wherein t is time and $t_{jc}$ is the time length of the time domain jerk curve.
4. The method of example 2 or 3, wherein the time domain jerk curve is a square raised cosine shape.
5. The method of example 1, wherein the time domain jerk curve comprises a Gaussian shape.
6. The method of example 5, wherein the Gaussian shape comprises an offset, wherein the offset is selected to have the zero value at the start and the end of the finite jerk time length of the Gaussian shape.
7. The method of example 5 or 6, wherein the Gaussian shape is defined as:

$$e^{-\frac{(t/t_{jg})^2}{2c^2}} - e^{-\left(\frac{1}{8c^2}\right)}, \quad -0.5t_{jg} < t < 0.5t_{jg},$$

wherein t is time, $t_{jg}$ is the time length of the time domain jerk curve and c is a tunable width parameter of the Gaussian shape.
8. The method of any of the examples 1-7, wherein the time domain jerk curve is a combination of a raised cosine shape and an Gaussian shape.

9. The method of any of the examples 1-8, wherein the time domain acceleration curve has a rectangular pulse shape.

10. The method of any of the examples 1-9, wherein the amplitude profile of the time domain jerk curve, when Fourier transformed into the frequency domain, has an amplitude that decreases for higher frequencies with at least 80 dB per decade.

11. The method of any of the preceding examples, wherein the movable object is an optical element of a projection system of a lithographic apparatus, or a substrate support or a patterning device support of a lithographic apparatus.

12. A setpoint generator arranged to generate an acceleration setpoint profile for a movable object, using a time domain acceleration curve with finite acceleration time length and a time domain jerk curve with finite jerk time length,

> wherein the setpoint generator is arranged to calculate a time domain convolution of the time domain acceleration curve and the time domain jerk curve to generate the acceleration setpoint profile,
> wherein the time domain jerk curve has a zero value at a start and an end of the finite jerk time length, and
> wherein an amplitude profile of the time domain jerk curve, when Fourier transformed into frequency domain, has an amplitude that decreases for higher frequencies with at least 60 dB per decade.

13. The setpoint generator of example 12, wherein the time domain jerk curve comprises a raised cosine shape.

14. The setpoint generator of example 13, wherein the raised cosine shape is defined as:

$$\frac{\cos(2\pi t/t_{jc}) + 1}{2}, \; -0.5t_{jc} < t < 0.5t_{jc},$$

wherein t is time and $t_{jc}$ is the time length of the time domain jerk curve.

15. The setpoint generator of example 12 or 13, wherein the time domain jerk curve is a squared raised cosine shape.

16. The setpoint generator of example 12, wherein the time domain jerk curve comprises a Gaussian shape.

17. The setpoint generator of example 16, wherein the Gaussian shape comprises an offset, wherein the offset is selected to start and end the Gaussian shape at zero.

18. The setpoint generator of example 16 or 17, wherein the time domain Gaussian shape is defined as:

$$e^{-\frac{(t/t_{jg})^2}{2c^2}} - e^{-\left(\frac{1}{8c^2}\right)}, \; -0.5t_{jg} < t < 0.5t_{jg},$$

wherein t is time, $t_{jg}$ is the time length of the jerk curve and c is a tunable width parameter of the Gaussian curve.

19. The setpoint generator of any of the examples 12-18, wherein the time domain jerk curve is a combination of a raised cosine shape and a Gaussian shape.

20. The setpoint generator of any of the examples 12-19, wherein the time domain acceleration curve is has a rectangular pulse shape.

21. The setpoint generator of any of the examples 12-20, wherein the amplitude profile of the time domain jerk curve, when Fourier transformed into the frequency domain, has an amplitude that decreases for higher frequencies with at least 80 dB per decade.

22. The setpoint generator of any of the examples 12-21, wherein the movable object is an optical element of a projection system of a lithographic apparatus, or a substrate support or a patterning device support of a lithographic apparatus.

23. Lithographic apparatus comprising the setpoint generator of any of the examples 12-22.

**Claims**

1. A method to generate an acceleration setpoint profile for a movable object, wherein the method comprises:

> providing a time domain acceleration curve with finite acceleration time length, providing a time domain jerk curve with finite jerk time length,
> calculating a time domain convolution of the time domain acceleration curve and the time domain jerk curve to generate the acceleration setpoint profile,
> wherein the time domain jerk curve has a zero value at a start and an end of the finite jerk time length, and
> wherein an amplitude profile of the time domain jerk curve, when Fourier transformed into frequency domain, has an amplitude that decreases for higher frequencies with at least 60 dB per decade.

2. The method of claim 1, wherein the time domain jerk curve comprises a raised cosine shape.

3. The method of claim 2, wherein the raised cosine shape is defined as:

$$\frac{\cos(2\pi t/t_{jc})+1}{2}, -0.5t_{jc} < t < 0.5t_{jc},$$

wherein t is time and $t_{jc}$ is the time length of the time domain jerk curve.

4. A setpoint generator arranged to generate an acceleration setpoint profile for a movable object, using a time domain acceleration curve with finite acceleration time length and a time domain jerk curve with finite jerk time length,

wherein the setpoint generator is arranged to calculate a time domain convolution of the time domain acceleration curve and the time domain jerk curve to generate the acceleration setpoint profile,
wherein the time domain jerk curve has a zero value at a start and an end of the finite jerk time length, and
wherein an amplitude profile of the time domain jerk curve, when Fourier transformed into frequency domain, has an amplitude that decreases for higher frequencies with at least 60 dB per decade.

5. The setpoint generator of claim 4, wherein the time domain jerk curve comprises a raised cosine shape.

6. The setpoint generator of claim 5, wherein the raised cosine shape is defined as:

$$\frac{\cos(2\pi t/t_{jc}) + 1}{2}, -0.5t_{jc} < t < 0.5t_{jc},$$

wherein t is time and $t_{jc}$ is the time length of the time domain jerk curve.

7. The setpoint generator of claim 4 or 5, wherein the time domain jerk curve is a squared raised cosine shape.

8. The setpoint generator of claim 4, wherein the time domain jerk curve comprises a Gaussian shape.

9. The setpoint generator of claim 8, wherein the Gaussian shape comprises an offset, wherein the offset is selected to start and end the Gaussian shape at zero.

10. The setpoint generator of claim 8 or 9, wherein the time domain Gaussian shape is defined as:

$$e^{-\frac{(t/t_{jg})^2}{2c^2}} - e^{-\left(\frac{1}{8c^2}\right)}, -0.5t_{jg} < t < 0.5t_{jg},$$

wherein t is time, $t_{jg}$ is the time length of the jerk curve and c is a tunable width parameter of the Gaussian curve.

11. The setpoint generator of any of the claims 4-10, wherein the time domain jerk curve is a combination of a raised cosine shape and a Gaussian shape.

12. The setpoint generator of any of the claims 4-11, wherein the time domain acceleration curve is has a rectangular pulse shape.

13. The setpoint generator of any of the claims 4-12, wherein the amplitude profile of the time domain jerk curve, when Fourier transformed into the frequency domain, has an amplitude that decreases for higher frequencies with at least 80 dB per decade.

14. The setpoint generator of any of the claims 4-13, wherein the movable object is an optical element of a projection system of a lithographic apparatus, or a substrate support or a patterning device support of a lithographic apparatus.

15. Lithographic apparatus comprising the setpoint generator of any of the claims 4-14.

Fig. 1

Fig. 2

Fig. 3

J      A      AP

$\ast$    = 

$t_j$      $t_a$      $t_j + t_a$

**Fig. 4**

Jc      A      APc

$\ast$    =

$t_{jc}$      $t_a$      $t_{jc} + t_a$

**Fig. 5**

Jg      A      APg

$\ast$    =

$t_{jg}$      $t_a$      $t_{jg} + t_a$

**Fig. 6**

Fig. 7

Europäisches
Patentamt

European
Patent Office

Office européen
des brevets

## EUROPEAN SEARCH REPORT

Application Number

EP 22 21 6697

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/320068 A1 (BOWLING DAVID G [US] ET AL) 25 December 2008 (2008-12-25) | 1,4, 8-10,12, 13 | INV. G03F7/00 G05B19/416 |
| Y | * paragraphs [0003], [0045], [0052], | 14,15 | |
| A | [0057], [0065] - [0068]; figures 6, 7E, 7F, 8 * | 2,3,5-7, 11 | |
| A | US 2007/032890 A1 (ZHOU LI [US] ET AL) 8 February 2007 (2007-02-08) * paragraphs [0061] - [0067] * | 1-15 | |
| A | US 2005/094309 A1 (LEE SANG-CHEOL [KR]) 5 May 2005 (2005-05-05) * paragraphs [0044] - [0083]; figures 3-7 * | 1-15 | |
| A | EP 0 419 705 A1 (SIEMENS AG [DE]) 3 April 1991 (1991-04-03) * page 5, line 17 - page 6, line 10; figures 5-7 * | 1-15 | |
| Y | US 2005/128460 A1 (VAN DEN BIGGELAAR PETRUS MARIN [NL] ET AL) 16 June 2005 (2005-06-16) | 14,15 | TECHNICAL FIELDS SEARCHED (IPC) G03F G05B |
| A | * paragraphs [0008] - [0010], [0080]; figures 2, 4 * | 1-13 | |
| Y | US 2007/258079 A1 (KAMIDI RAMIDIN I [NL] ET AL) 8 November 2007 (2007-11-08) | 14,15 | |
| A | * paragraphs [0046] - [0048]; figure 3 * | 1-13 | |
| Y | EP 1 480 093 A1 (ASML NETHERLANDS BV [NL]) 24 November 2004 (2004-11-24) | 14,15 | |
| A | * paragraphs [0043] - [0047]; figure 3 * | 1-13 | |

The present search report has been drawn up for all claims

| Place of search | Date of completion of the search | Examiner |
|---|---|---|
| Munich | 17 May 2023 | Weckesser, Jens |

EPO FORM 1503 03.82 (P04C01)

## ANNEX TO THE EUROPEAN SEARCH REPORT
## ON EUROPEAN PATENT APPLICATION NO.

EP 22 21 6697

This annex lists the patent family members relating to the patent documents cited in the above-mentioned European search report.
The members are as contained in the European Patent Office EDP file on
The European Patent Office is in no way liable for these particulars which are merely given for the purpose of information.

17-05-2023

| Patent document cited in search report | | Publication date | Patent family member(s) | | Publication date |
|---|---|---|---|---|---|
| US 2008320068 | A1 | 25-12-2008 | NONE | | |
| US 2007032890 | A1 | 08-02-2007 | NONE | | |
| US 2005094309 | A1 | 05-05-2005 | EP | 1533794 A1 | 25-05-2005 |
| | | | JP | 4758633 B2 | 31-08-2011 |
| | | | JP | 2005141899 A | 02-06-2005 |
| | | | KR | 20050041528 A | 04-05-2005 |
| | | | US | 2005094309 A1 | 05-05-2005 |
| EP 0419705 | A1 | 03-04-1991 | EP | 0419705 A1 | 03-04-1991 |
| | | | US | 5073748 A | 17-12-1991 |
| US 2005128460 | A1 | 16-06-2005 | JP | 2005183966 A | 07-07-2005 |
| | | | US | 2005128460 A1 | 16-06-2005 |
| US 2007258079 | A1 | 08-11-2007 | JP | 5002317 B2 | 15-08-2012 |
| | | | JP | 2007318107 A | 06-12-2007 |
| | | | US | 2007258079 A1 | 08-11-2007 |
| EP 1480093 | A1 | 24-11-2004 | NONE | | |

EPO FORM P0459

For more details about this annex : see Official Journal of the European Patent Office, No. 12/82

**EP 4 394 502 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20070058173 A1
- US 6020964 A